# EUROPEAN PATENT APPLICATION

(11) **EP 4 755 664 A1**
(43) Date of publication of application: **10.06.2026**
(21) Application number: 25217006.3
(22) Date of filing: 19.11.2025
(51) Int. Cl.: B60C 23/04, B60C 23/06, H03K 17/955

(54) **TIRE SENSOR SYSTEM AND METHOD**

(30) Priority: 05.12.2024 US 202463728344 P
(71) Applicant: Semtech Corporation, Camarillo CA 93012-8790 (US)
(72) Inventor: Rouaissia, Chaouki, 2000 Neuchâtel (CH)
(74) Representative: P&TS SA (AG, Ltd.)

(57) **Abstract**

Tire sensor system mountable in a wheel of a vehicle for determining a desired characteristic of the wheel or of a tire thereof or of a road, comprising: an autonomous source of electric energy, a conductor, a wireless data interface transmitting to the vehicle a signal that provides the desired characteristics, characterized by an electronic circuit configured to acquire, filter and digitize a capacitance of the conductor and to determine the signal transmitted to the vehicle based on the digitized capacitance.

## Description

### Technical domain

The present invention concerns a wireless instrument to monitor vehicles' wheels and the corresponding method.

### Related art

Tire pressure monitoring system (TPMS) have been adopted by many carmakers and are indeed compulsory in most significant automotive markets since many years. In many implementations of this concept, each tire is equipped with a disposable TPMS device that is fixed on the rim, facing the internal air space. Disposable TPMS devices includes an autonomous energy source-typically button primary cells-designed to last for many years, a pressure sensor, and a mixed miniaturized circuit configured to acquire, digitize and process the internal tire pressure, then transmit wirelessly to the vehicle a signal suitable for alerting the user when the pressure of any tire drops below a pre-programmed threshold.

Often, TPMS systems and the inflation valve are integrated together and make a single replaceable part. The wireless transmission may happen in specific bands of the radio spectrum, for example at 315 MHz or 433 MHz. Recently, Bluetooth Low Energy (BTLE) is more and more used, providing a bidirectional secure link in these applications.

TPMS system may include other sensors beyond pressure ones. US patent 10,850,578, for example, discloses a TPMS system with acceleration sensors and temperature sensors.

Capacitive sensors are commonly used in electronic devices as proximity sensors and touch input devices. US patent 11,082,550 in the name of the present applicant provides an example, among many.

### Short disclosure of the invention

One aim of the present invention is the provision of a sensor system and a method that overcomes at least some of the shortcomings and limitations of the state of the art.

According to the invention, these aims are attained by the object of the attached claims, and in particular by a tire sensor system mountable in a wheel of a vehicle for determining a desired characteristic of the wheel or of a tire thereof or of a road, comprising: an autonomous source of electric energy, a conductor, a wireless data interface transmitting to the vehicle a signal that provides the desired characteristics, characterized by an electronic circuit configured to acquire, filter and digitize a capacitance of the conductor and to determine the signal transmitted to the vehicle based on the digitized capacitance. The conductor will be referred to in the following also as "sense electrode".

Dependent claims relate to important and useful, but not essential, features. The tire sensor system is intended for installation in a wheel of a car, truck, motorcycle, or any other road or off-road vehicle. The location of the conductor will be chosen such that the capacitance indicates an instantaneous proximity between the conductor and the road surfaces and, according to the rotation angle of the wheel, nearby surfaces of the vehicle, like the mudguard, for example. By analyzing the time evolution of the capacitance, the system can deduce the desired characteristics that may be, for example, an angle of rotation of the wheel, its angular speed, the direction of rotation. The value of capacitance is also influenced by the compression of the tire, therefore by the load of the wheel, and the sensor system may be configured to extract these elements of information also.

The position of the wheel relative to the vehicle body provides information on the shock absorbers position and this, alone or in combination with the compression of the tire may be used to determine road quality (smooth versus bumpy) and whether the road surface is wet or dry. These values can be used to improve the precision of the pressure measurement (correcting the measured pressure taking the compression into account). The values of tire loads and shock absorber positions may be provided to an ESP system to better control the stability of the vehicle. Thread height has also an influence on the measured capacitance, and the system may be used to determine the wear status of the tire. The determination of the rotation direction may be a valuable input to parking assistance systems.

The tire sensor system of the invention may be located on a rim of the wheel facing the inner air chamber or on an inner surface of the tire facing the air chamber or buried in the tire material. Advantageous, the conductor can be realized as a metallized surface on a flexible or rigid printed circuit; therefore, the sensor system of the invention can be realized very economically, adapting the conductor's geometry to the available space in different vehicles, wheels and tires is straightforward, and the capacitive electrode itself is remarkably light, with little or no influence on the wheels' balance.

To improve the capacitance determination, the conductor is preferably protected by an adjacent active shield driven by the electronic circuit and/or by a passive shield tied to ground.

The invention includes also the corresponding methods of determining a desired characteristic of a tire or of a wheel or of a road in a vehicle, defined by the claims in the corresponding category.

### Short description of the drawings

Exemplar embodiments of the invention are disclosed in the description and illustrated by the drawings in which:
Figure 1 shows, in simplified fashion, a wheel of a vehicle equipped with the contact monitoring system of the invention.
Figure 2 is a simplified schematic diagram of the contact monitoring system of the invention.
Figure 3 is a simplified example, among many possible variants, of a circuit used in the invention to convert a self-capacitance of a generic electrode into a digital value.
Figure 4 illustrates an example of digital processing that may be used in the current invention.
Figure 5 shows the functioning of the invention, in a rolling tire.

In the figures, remarkable elements are identified by reference signs that are repeated in the text. The same reference sign may be used to identify distinct elements that are identical, similar, logically related, or technically equivalent. When many identical, similar, related or equivalent elements occur on a drawing, some reference signs may have been omitted to avoid cluttering.

### Examples of embodiments of the present invention

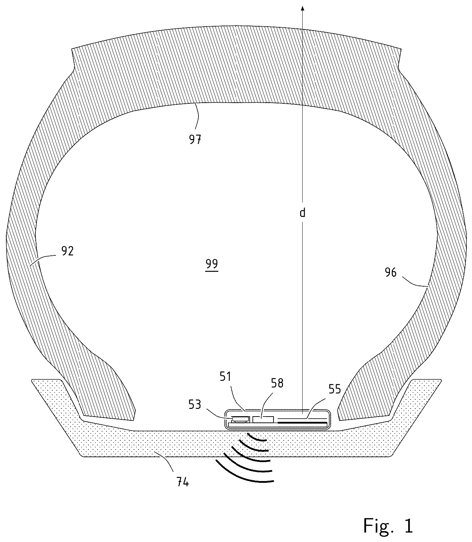

**Figure 1** shows an example of the invention with a sensor system 51 mounted on a rim 74 of a vehicle wheel, facing the inner air space 99. The sensor comprises an autonomous energy source 53, for example a button cell, a conductor 55 configured as capacitive sense electrode, and a circuit 58 capable of determining the self-capacitance of the sense electrode, estimate a distance d between the electrode and conductive or high-permeability bodies in front, process the result and transmit the information wirelessly to the vehicle, for example to an ECU.

The positioning of the sensor system on the rim is that most commonly adopted for TPMS system and presents some advantages: the sensor can be integrated with the air valve, does not interfere with tire changes and repair, and has little influence on the balance or ride characteristics of the wheel. It is not the only one possible, however. The system-or the sole electrode 55, which is very light-could be positioned elsewhere, for example on the inner face of the side wall 96, on the ceiling 97 of the inner space 99, or embedded in the material of the tire 92.

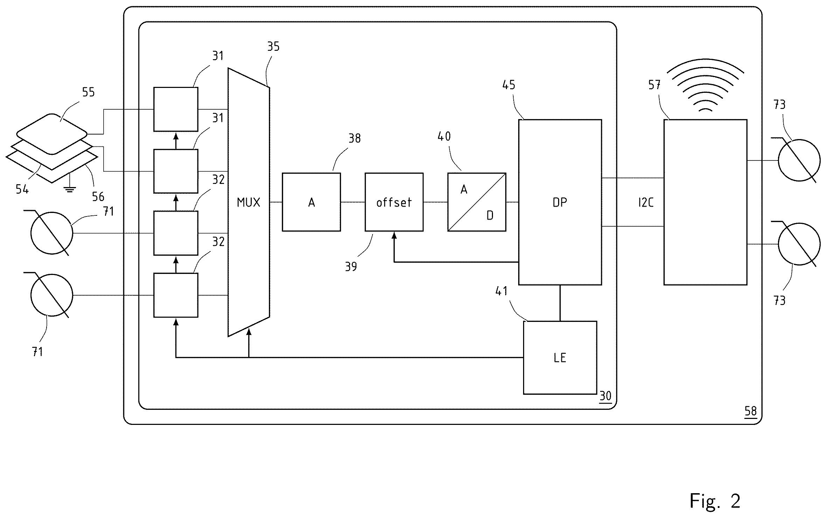

**Figure 2** shows an electronic circuit 30. The detector has two inputs connectable to the capacitive sense electrode 55, respectively to the active shield electrode 54 that is located below. An optional ground shield 56 is also provided. It should be understood that the configuration of electrodes and shields shown here is purely to illustrate an example and may vary considerably. The number of sense electrodes, shields and ground planes is not constrained.

In this example, but this is entirely optional, the circuit provides additional inputs connectable to more capacitive sense electrodes or shields, or to other generic sensors 71, for example temperature and pressure sensors. The underlying mechanism to convert temperature, force or pressure into an electric signal may be capacitive, resistive, inductive, or have any other nature.

Internally, the capacitive detector 30 has an analog/digital converter 40 that transforms the capacitance signal to a digital signal suitable for further processing in a digital processor 45. Preferably, a common converter is used to read the capacitances seen by the sense electrodes in turn, through a multiplexer 35. This is not an absolute requirement, however.

The input units 31 linked to the capacitive sense electrodes are configured to set the corresponding input terminals to a desired state chosen among a measure state, a ground state, a high-impedance state and a shield state. In the measure state, the electric potential of the input is variable, following a variable voltage source in the capacitive sensor device, and the resulting variation of electric charge are sent to the ADC to determine a capacitance value. In the ground state the input is held at a constant voltage, either the voltage of the ground or shifted by a fixed value. In the shield state, the voltage at the input follows that of another input that is in the measure state, but the variations of electric charge are disregarded.

Input units 32 will be configured based on the specific requirements of the sensors attached thereto. They may be the same as units 31 if the sensors 71 are capacitive in nature, or different if other principles are used, for example if there are thermistors or resistive pressure transducers.

Circuit 30 includes also a logic engine 41 that orchestrates the general functions of the system, activates the required input units and the multiplexer in sequence, determines the use mode (measure, shield, ground, high-Z or other) of each input, and so on.

Further right, circuit 30 is connected to a host processor 57 that receives the capacitance and sensor measurements, process them further if required, and transmits them to the vehicle over a suitable wireless link. The host processor may, optionally, have optional analogue input pins that serve other sensors 73, and whose readouts are also transmitted on the wireless channel. Preferably the wireless channel is bidirectional and allows the sensor system to be reprogrammed or tuned on site. The wireless link may be radio-based and use a Bluetooth LE radio, or a transmitter at 315 MHz or 433 MHz, according to the vehicle's requirements. The antenna may be a planar antenna etched on the printed circuit on which the system is mounted and, in an especially advantageous combination, the same conductor pad 55 may provide double service as proximity electrode and antenna, the two signal being separated in frequency enough not to interfere with each other.

The configuration shown in this example is not essential: the invention may include also variants in which the system comprises more than two integrated circuits, as well as other variants where all the system is integrated in a single chip or package.

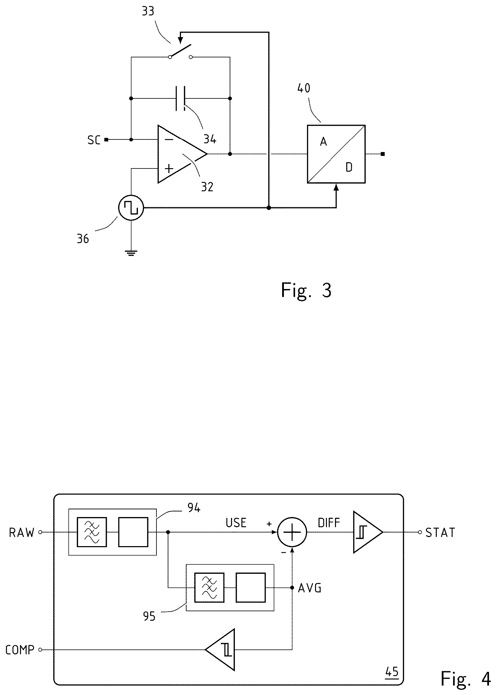

**Figure 3** shows, in a very simplified form, a possible implementation of an input unit that causes the voltage at the input to follow a variable voltage source and could be used in the frame of this invention to convert a capacitance into a digital value with the ADC 40. This is provided for the completeness of the disclosure and by way of example, but the invention includes also other structures of input stages that can provide the desired function. The sense electrode is connected to the SC node that is linked to an inverting input of an amplifier 32, while the other input is driven by a voltage source 36 that can provide a variable voltage, or a constant voltage. Thanks to the feedback, the SC node is a low impedance one and its voltage is the same as that of the voltage source 36 (possibly with a constant offset that has no importance in this application).

The ground state of the input SC can be obtained by causing the source 36 to generate a constant voltage. The input node SC is then a virtual ground. The measure state and the shield state are obtained when the source 36 generates a variable voltage. Node SC follows then that voltage.

The capacitance of the sense electrode connected to the SC node can be measured by causing the source 36 to generate a series of steps. The capacitor 34 connected in the reaction loop gives an integrator and the output of the amplifier 32 will show steps proportional to the variation of electric charge on the sense electrode. The ratio between the charge, measurable as a step voltage at the output of amplifier 32, and the known voltage steps of the source 36 is, by definition, the capacitance that is sought. The switch 33 is used to discharge periodically the reaction capacitor 34. The input unit may also include switching means (not shown) to disconnect the node SC and leave it in an high-impedance state.

The output signal is digitized by ADC converter 40, preferably synchronously with the pulses of source 36. The multiplexer 35, preamplifier 38 and offset correction 39 are not represented in this figure but could be present.

**Figure 4** is a schematic illustration of the digital processing that takes place in digital processor 45, for example. The raw data coming from the ADC is treated by a first low pass filter 94 that may include linear and nonlinear filter elements. The resulting variable (USE) is also given to a baseline determining unit 95, that may also include a linear low-pass filter, used as average, and non-linear operations, and the average baseline (AVG) is subtracted from the filtered signal and gives rise to a difference capacitance (DIFF). Importantly, the average baseline is also given to a discriminator and, when its value exceeds a set threshold, a signal is fed back to the analogue offset compensation circuit 39 of figure 3. A second comparator provides a logical proximity flag (STAT). The circuit is drawn as if the logical flag (STAT) constitutes the output but, in concrete realizations, all the variables (RAW, USE, AVG, DIFF, STAT) may be transmitted to the host system or to the vehicle according to the needs.

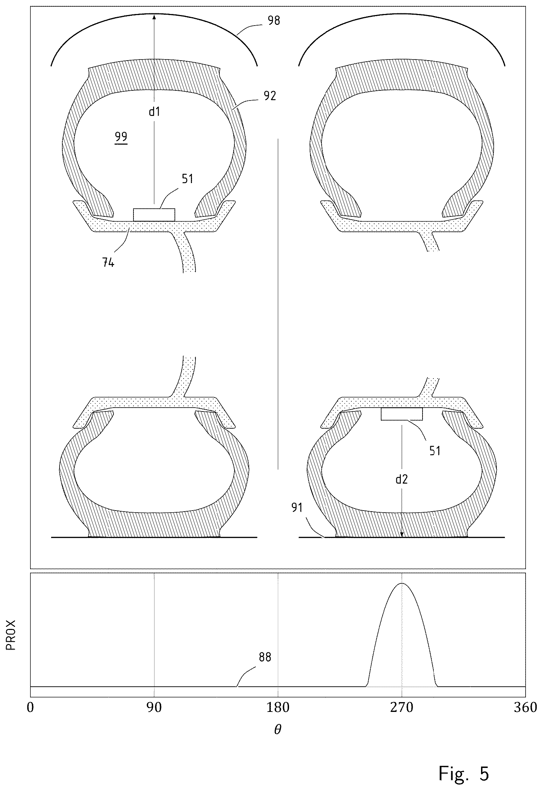

**Figure 5** illustrates the functioning of an embodiment of the invention. The upper part of the drawing shows a car wheel equipped with the inventive sensor system 51 on rim 74, facing the inner air space 99, in two orientations. In the first one, conventionally assigned to a rotation angle *θ* = 90°, the sensor is facing up and delivers a proximity signal that is influenced, mainly, by the distance d1 to whatever conducting body that is located above-in this case a mudguard 98.

The second orientation is opposite to the first one, at a rotation angle *θ* = 90° + 180° = 270°. The sensor 51 is facing down and delivers a proximity signal determined by the distance d2 to the road surface below. Since d2 is considerably shorter than d1, both because the road surface 91 touches the thread surface of the tire and due to the tire's compression under the load, the proximity signal will show a peak whenever the wheel assumes this orientation.

The lower part of the drawing plots the proximity signal 88 during one full revolution of the wheel, showing a peak at *θ* = 270°. The signal shown is the DIFF signal (see fig. 4) after the baseline subtraction and shows only the effect of the proximity with the road surface 91.

When the car is moving, the PROX signal exhibits a periodic repetition of peaks whenever the sense pad is looking down. The period between the peaks is proportional to the angular velocity of the wheel, while the height of the peak is linked to the distance d2 and is influenced by tire compression and thread wear. The system sensor of the invention can then extract these characteristics from the proximity signal 88. Tire compression may be used to determine an index of the road smoothness or bumpiness and may reveal a wet road condition. All these characteristics are transmitted to the vehicle to improve stability and handling and/or to warn the driver.

Signal 88 shows only the effect of the road surface 91 and the plot far from the peak at *θ* = 270° is featureless; however, the measuring system is influenced also by parts of the vehicle like the mudguard 98 at distance d1. One expects in this case a broader and less pronounced peak centered around *θ* = 90°. These features of signal 88 can be exploited to extract other desired characteristics, for example from the distance between the rotation axe and the mudguard 98, which is linked to the extension of the shock absorbers. This information can be used in the sensor system to extract an index of road quality (bumpy or smooth) or its wet/dry condition, transmit these to the vehicle's ECU and/or to the driver to improve handling and safety.

The compression of the tire can influence the pressure readout and is a source of error in conventional TPMS systems. The system of the invention can compensate for this effect and provide a more accurate pressure reading in dynamic conditions. Differential values of compression across the four wheels are also significant for the stability of the vehicle and can be transmitted to an ESP system for that purpose.

The sensor system of the invention can be programmed to detect differences in the rotation speed and rotation sense of the wheels, which may be useful in assisted parking systems.

The system and method disclosed herein are open to several variations and improvements, without leaving the scope of the appended claim. For example, the system may include more than one sense electrode, positioned at different angles on the rim, or on the tire. This additional information may be used to determine the rotation angle of the wheel more exactly, as well as its rotation sense. Multiple electrodes may be oriented differently, to be more sensitive to proximity of different objects, for example to discriminate between a signal induced by proximity to the road and another induced by proximity to a part of the vehicle. To the same effect, the directionality of the capacitive sensors can be made variable by arranging programmable shield electrodes that can be switched between an active shield condition and a grounded condition or to a high-Z condition.

### Reference symbols in the figures

- 30: capacitive proximity sensor circuit
- 31: C to V converter
- 32: generic analogue front-end
- 33: reset switch
- 34: integration capacitor
- 35: multiplexer
- 36: variable voltage source
- 38: analogue preprocessing
- 39: offset subtraction
- 40: ADC
- 41: logic engine
- 45: digital data processing
- 51: Tire contact sensor
- 53: battery, energy source
- 54: shield
- 55: sense pad
- 56: ground plane
- 57: host
- 58: electronic circuit
- 71: sensor
- 73: sensor
- 74: rim
- 88: proximity signal
- 91: road
- 92: tire
- 94: ADC and raw low-pass filter
- 95: average unit
- 96: inner side wall
- 97: ceiling
- 98: mudguard
- 99: inner air space

## Claims

1. Tire Sensor System (51) mountable in a wheel of a vehicle for determining a desired characteristic of the wheel or of a tire (92) thereof or of a road, comprising:
- an autonomous source of electric energy (53)
- a conductor (55),
- a wireless data interface transmitting to the vehicle a signal that provides the desired characteristics, **characterized by**
- an electronic circuit configured (58) to acquire, filter and digitize a capacitance of the conductor (55) and to determine the signal transmitted to the vehicle based on the digitized capacitance.

2. The tire sensor system (51) of the preceding claim installed in the wheel, the conductor (55) being placed such that the capacitance indicates an instantaneous proximity between the conductor and a road (91) and/or surfaces of the vehicle adjacent the wheel (98) that varies along with a rotation angle of the wheel.

3. The tire sensor system of the preceding claim, the conductor (55) being located on a rim of the wheel facing the inner air chamber or on an inner surface (96. 97) of the tire facing the air chamber or buried in the tire material (92).

4. The tire sensor system of any one of the preceding claims, the conductor (55) being a metallized surface on a flexible or rigid printed circuit.

5. The tire sensor system of any one of the preceding claims, the conductor (55) being adjacent to an active shield (54) driven by the electronic circuit (58) such that a potential of the active shield (54) follows a potential of the conductor (55) during an acquisition of the capacitance, and/or to a passive shield (56) tied to ground.

6. The tire sensor system of any one of the preceding claims, the desired characteristic being one of: wheel instantaneous angle of the wheel, angular velocity of the wheel, direction of rotation of the wheel, tire compression, tire load, tread wear, position of shock absorber, road quality, road wetness.

7. A method of determining a desired characteristic of a tire or of a wheel or of a road in a vehicle, comprising:
- providing in the wheel an autonomous energy source (53), a conductor (55), a wireless data interface transmitting to the vehicle a signal that provides the desired characteristics, **characterized by**
- acquiring, filtering and digitizing with an electronic circuit (58) a capacitance of the conductor (55),
- determine the signal transmitted to the vehicle based on the digitized capacitance.

8. The method of the preceding claim comprising placing the conductor in the wheel such that its self-capacitance depends on a rotation angle of the wheel through variations of an instantaneous proximity between the conductor and a road (91) and/or surfaces of the vehicle adjacent the wheel (98).

9. The method of any one of claims 7-8, comprising determining one of: wheel instantaneous angle of the wheel, angular velocity of the wheel, direction of rotation of the wheel, tire compression, tire load, tread wear, position of shock absorber, road quality, road wetness.
